# EUROPÄISCHE PATENTSCHRIFT

(11) **EP 0 849 854 B1**
(45) Veröffentlichungstag und Bekanntmachung des Hinweises auf die Patenterteilung: **18.06.2003**
(21) Anmeldenummer: 97121481.2
(22) Anmeldetag: 05.12.1997
(51) Int. Cl.: H02H 9/02, H02M 3/335

(54) **Elektronisches Schaltnetzteil**
Switched electronic supply unit
Bloc électronique d'alimentation à découpage

(30) Priorität: 18.12.1996 DE 19652808
(43) Veröffentlichungstag der Anmeldung: 24.06.1998
(73) Patentinhaber: Patent-Treuhand-Gesellschaft für elektrische Glühlampen mbH, 81543 München (DE)
(72) Erfinder: Huber, Andreas, 83301 Traunreut (DE)

(56) Entgegenhaltungen:
- EP-A- 0 649 222
- WO-A-97/40545
- US-A- 5 198 743

## Beschreibung

Die Erfindung bezieht sich auf ein elektronisches Schaltnetzteil gemäß dem Oberbegriff des Patentanspruches 1.

Aus einer Netzwechselspannung gespeiste Netzteile zur Gleichstromversorgung einer Last sind in einer Vielzahl von Ausführungsformen bekannt. Einen Überblick über dafür gebräuchliche Schaltungsprinzipien gibt beispielsweise Tietze-Schenk "Halbleiter-Schaltungstechnik", Springer Verlag Berlin, 9. Auflage 1989 im Abschnitt 18.5 "Schaltnetzgeräte", S. 561 ff. Vereinfacht ausgedrückt, umfassen derartige Schaltnetzteile eine an die speisende Netzwechselspannung angeschlossene Gleichrichterschaltung, die häufig als Gleichrichterbrücke ausgeführt ist. Die Gleichrichterschaltung liefert eine pulsierende Gleichspannung, die in einer mit ihr verbundenen Ausgangsstufe des Schaltnetzteiles in eine geglättete Gleichspannung umgewandelt wird. Diese Ausgangsstufen können, wie in dem genannten Dokument detaillierter dargelegt, je nach Anwendungsfall durchaus unterschiedlich, z. B. als Durchflußoder Sperrwandler ausgestaltet sein.

Für das einleitend bezeichnete elektronische Schaltnetzteil ist die Implementierung der Ausgangsstufe als solche von lediglich untergeordnete Bedeutung, da es in Verbindung mit einer Vielzahl an sich bekannter Ausgangsstufen einzusetzen ist. Wesentlicher aber dabei ist, daß in den Ausgangsstufen üblicherweise die geglättete Ausgangsgleichspannung an einem speichernden Kondensator relativ hoher Kapazität abgenommen wird. Das notwendige Laden dieses Speicherkondensators bei Inbetriebnahme des Schaltnetzteiles bedingt einen entsprechenden hohen Einschaltstrom, für den nicht nur das Schaltnetzteil selbst ausgelegt sein muß, sondern auch die gesamte Versorgungskette auf der davor liegenden Eingangsseite.

In diesem Zusammenhang ist aus DE-A-34 02 222 eine Schaltungsanordnung zum Begrenzen von Überspannungen in Gleichstrom-Bordnetzen bekannt. Dabei ist ein steuerbarer Schalter in die auf niedrigem Potential liegende Netzleitung mit seiner Schaltstrecke eingesetzt. Weiterhin ist ein Komparator mit zwei Eingängen vorgesehen. Einer dieser Eingänge ist über eine Konstantspannungsquelle mit der Ausgangsseite dieser Schaltstrecke und der zweite dieser Eingänge mit der anderen Netzleitung verbunden. Der Komparator vergleicht die ihm über seine beiden Eingänge zugeführten Signale und steuert den Schalter derart, daß ein an diese Schaltungsanordnung angeschlossenes Gerät bei Überspannungen vom Netz getrennt wird. Der steuerbare Schalter kann ferner als Halbleiterschalter ausgebildet sein. Dies ermöglicht mittels eines in seinem Ansteuerkreis liegenden Kondensators bei einer hohen kapazitiven Belastung durch das angeschlossene Gerät den hohen Einschaltstromstoß zu reduzieren.

Ferner ist aus EP-A-0 423 885 eine Stromversorgungseinrichtung mit einer Schaltung zur Einschaltstrombegrenzung bekannt. Diese Schaltung weist einen ersten Halbleiterschalter auf, dessen Schaltstrecke zusammen mit einem ihr parallel liegenden Widerstand in die auf niedrigem Potential liegende Versorgungsleitung eingeschaltet ist. Im Ansteuernetzwerk dieses ersten Halbleiterschalters sind ein RC-Glied sowie parallel dazu die Schaltstrecke eines zweiten Halbleiterschalters vorgesehen. Die Steuerelektrode des zweiten Halbleiterschalters ist an den Abgriff eines Spannungsteilers angeschlossen, dem seinerseits ein zweiter Kondensator parallel liegt. Außerdem ist die Schaltstrecke eines dritten Halbleiterschalters zwischen dem Abgriff des Spannungsteilers und der auf niedrigem Potential liegenden Versorgungsleitung angeschlossen. Dieser dritte Halbleiterschalter wird in Abhängigkeit eines von einer Schwellwertschaltung gelieferten Steuerstromes so gesteuert, daß er bei Unterschreiten eines vorgegebenen Schwellwertes der Versorgungsspannung sperrt.

Speziell die zuletzt genannte bekannte Schaltungsanordnung ist - bei allen funktionalen Vorteilen - schaltungstechnisch sehr aufwendig. Beiden bekannten Schaltungsanordnungen ist ferner gemeinsam, daß sie eine angeschlossene Ausgangsstufe bzw. ein mit der Versorgungsspannung versorgtes Gerät durch einen in die auf niedrigem Potential liegende Versorgungs- bzw. Netzleitung eingekoppelten Schalter von der Gleichstromversorgung trennen, sie sind Schaltnetzteile mit sogenannten "Low-Side"-Schaltern. Üblicherweise liegt diese Versorgungsleitung auf Massebezugspotential. Damit kann sich bei den verschiedenen Betriebszuständen an unterschiedlichen Baugruppen ein verschiedenes Massebezugspotential ergeben, das beim Schaltungsentwurf zu berücksichtigen ist und die Implementierung der Schaltung durchaus erschweren kann.

Bei sogenannten Schaltnetzteilen mit "High Side"-Schaltern mit gesteuerten Schaltern, deren Schaltstrecke in die auf hohem Gleichspannungspotential liegende Versorgungsleitung eingekoppelt ist, kann dieser Aufwand vermieden werden. Dort werden aber für die gesteuerten Schalter, wenn sie denn als Halbleiterschalter ausgebildet sind, üblicherweise P-Kanal-Typen mit deren bekannten Nachteilen eingesetzt.

Die Offenlegungsschrift EP 0 649 222 A2 beschreibt eine Schutzschaltung für ein Schaltnetzteil, die einen "High Side"-Schalter aufweist und das Schaltnetzteil vor Überlastung und im Falle eines Kurzschlusses schützt.

Die Patentschrift US 5,198,743 offenbart ein als Batterie-Ladegerät ausgebildetes Schaltnetzteil, das von einem Mikroprozessor gesteuert wird. Dieses Schaltnetzteil besitzt ein Transistorschaltglied, dessen Schaltstrecke zwischen dem auf hohen Pegel liegenden Ausgang einer Gleichrichterschaltung und dem entsprechenden Anschluß der Ausgangsstufe angeordnet ist.

Die Patentanmeldung mit der Veröffentlichungsnummer WO 97/40545, die einen Stand der Technik gemäß Artikel 54(3) und (4) EPÜ bildet, beschreibt ebenfalls ein als Batterie-Ladegerät ausgebildetes Schaltnetzteil mit einem Transistorschaltglied, dessen Schaltstrecke zwischen dem auf hohen Pegel liegenden Ausgang einer Gleichrichterschaltung und dem entsprechenden Anschluß der Ausgangsstufe angeordnet ist.

Der vorliegenden Erfindung liegt daher die Aufgabe zugrunde, ein Schaltnetzteil der eingangs genannten Art derart weiterzubilden, daß mit geringem Bauelementeaufwand ein gesteuertes Schalten der gleichgerichteten Netzwechselspannung in dem auf hohem Potential liegenden Zweig seiner Versorgung mit einem kostengünstigen Leistungshalbleiterschalter durchgeführt, damit eine Unterbrechung der auf niedrigem Potential liegenden Versorgungsleitung vermieden und zugleich eine gesteuerte Strombegrenzung ermöglicht wird.

Bei einem Schaltnetzteil der eingangs genannten Art wird diese Aufgabe durch die im Kennzeichen des Patentanspruches 1 angegebenen Merkmale gelöst.

Ein wesentlicher Vorteil der erfindungsgemäßen Lösung besteht darin, daß damit ein einwandfreies Ausschalten mit geringem Bauteileaufwand unter Verwendung von kostengünstigen Bauelementen gegeben ist, sich zugleich eine stabil gesteuerte Einschaltstrombegrenzung ermöglichen läßt, die wiederum den Einsatz kostengünstiger, weil kleiner zu dimensionierender Bauelemente nicht nur in der Ausgangsstufe zuläßt. Dies bedeutet auch, daß der Schaltungsaufwand auf der Versorgungssseite vermindert wird. Beispielsweise läßt sich bei größeren Anlagen die Anzahl der Sicherungsautomaten reduzieren, weil geringere Überstrombelastungen im Netz auftreten. Von besonderer Bedeutung ist dies dann, wenn das zu versorgende Gerät eine für übliche Gleichspannungsversorgungen auf relativ hohem Potential liegende Versorgungsspannung benötigt. Dennoch wird auch dann eine hohe Betriebssicherheit erreicht. Schließlich werden die im Strompfad liegenden Bauteile, da Stoßbelastungen vermieden werden, auch bei den Schaltvorgängen schonender betrieben. Im Hinblick auf den Speicherkondensator in der Leistungseinheit z.B. bedeutet dies, daß er alterungsbeständiger ist.

Weiterbildungen der Erfindung sind in Unteransprüchen beschrieben, deren Eigenschaften und Vorteile der nachfolgenden Beschreibung zu entnehmen sind.

Ausführungsbeispiele der Erfindung werden im folgenden anhand der Zeichnung näher erläutert, dabei zeigt:
Fig. 1 ein erfindungsgemäß ausgebildetes Schaltnetzteil, mit einer Gleichrichterbrücke und einer Ausgangsstufe, die als ein Hochsetzsteller eines elektronischen Vorschaltgerätes zum Betreiben von Leuchtstofflampen ausgebildet ist sowie einem zwischen diesen angeordneten elektronischen Schalter mit einem diesem zugeordneten Steuertransistor,
Fig. 2 und 3 je eine Schaltungsvariante in Verbindung mit einer Ausgangsstufe, die als Sperrwandler ausgebildet ist und
Fig. 4 eine weitere Ausführungsform, bei der dem elektronischen Schalter ein Optokoppler zugeordnet ist.

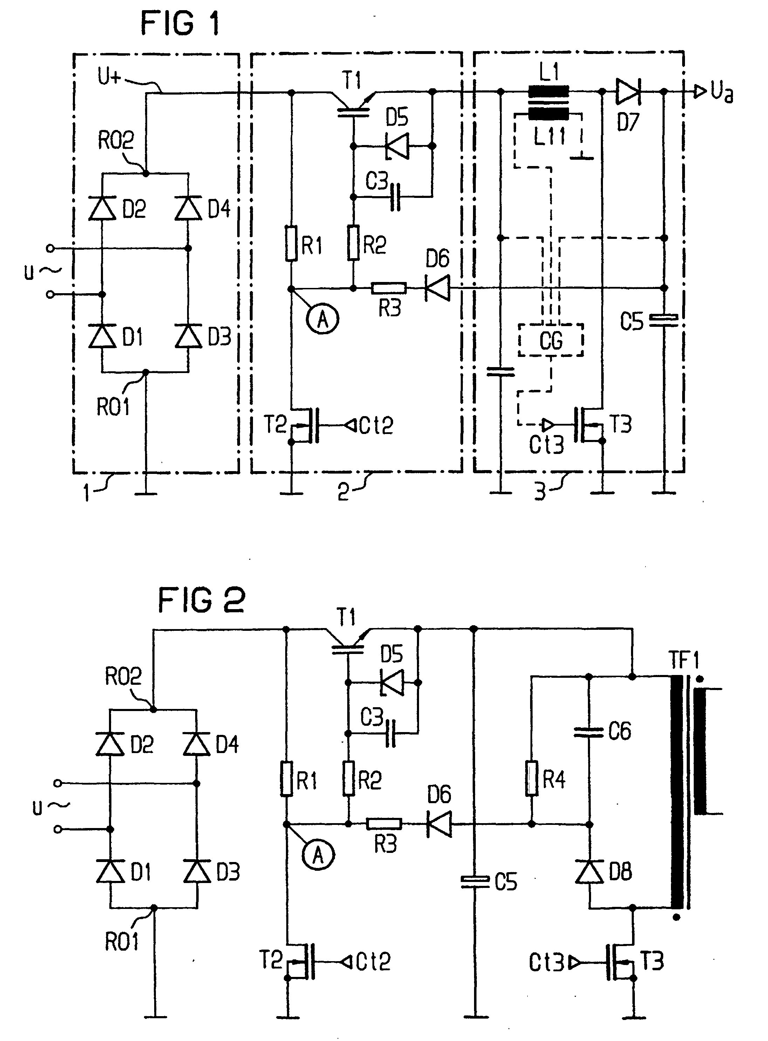

In Figur 1 ist als Beispiel ein Schaltnetzteil mit einer Ausgangsstufe ausgewählt, die als Hochsetzsteller eines elektronischen Vorschaltgerätes für Leuchtstofflampen ausgebildet ist. In diesem Beispiel wird eine Netzwechselspannung u∼ - gegebenenfalls über ein nicht dargestelltes Oberwellenfilter - einer Gleichrichterbrücke 1 zugeführt, die aus vier Dioden D1 bis D4 aufgebaut ist und zwei Ausgänge RO1 bzw. RO2 aufweist. Dabei ist der eine Ausgang RO1 der Gleichrichterbrücke 1 auf Massebezugspotential gelegt. Am zweiten Ausgang RO2, der auf hohem Potential liegt, gibt die Gleichrichterbrücke 1 eine aus der Netzwechselspannung u∼ abgeleitete gleichgerichtete Spannung U+ ab.

Dieser zweite Ausgang RO2 der Gleichrichterbrücke 1 ist über einen elektronischen Schalter 2, der nachstehend noch im einzelnen erläutert wird, mit dem Eingang eines Hochsetzstellers 3 verbunden. An diesen auf hohem Potential liegenden Eingang des Hochsetzstellers 3 ist eine Drossel L1 angeschlossen, die andererseits über eine in Durchlaßrichtung gepolte Ladediode D7 mit dem Pluspol eines als Elektrolytkondensator ausgebildeten Speicherkondensators C5 verbunden ist, dessen zweiter Pol auf Massebezugspotential gelegt ist. Der Verbindungspunkt zwischen Drossel L1 und Ladediode D7 ist über die Schaltstrecke eines Schalttransistors T3 ebenfalls auf Massebezugspotential gelegt. Der Pluspol des Speicherkondensators C5 bildet den Ausgang des Hochsetzstellers 3, an dem eine hochgesetzte, geglättete Gleichspannung Ua an eine in Figur 1 nicht mehr dargestellte Lampenschaltung abgegeben wird.

Die vorstehend beschriebene Schaltungsanordnung ist bei elektronischen Vorschaltgeräten für Leuchtstofflampen an sich als bekannt anzusehen. Mit Hilfe der Gleichrichterbrücke 1 wird aus der Netzwechselspannung u∼ die gleichgerichtete, pulsierende Gleichspannung U+ erzeugt und über den elektronischen Schalter 2 dem Hochsetzsteller 3 zugeführt. Ist der Schalttransistor T3 leitend geschaltet, steigt der Strom in der Drossel L1 im wesentlichen linear an. Bei Erreichen eines vorgesehenen Endwertes wird der Schalttransistor T3 gesperrt, so daß sich die in der Drossel L1 gespeicherte Energie über die Ladediode D7 in den Speicherkondensator C5 entlädt. Zum Zeitpunkt der Beendigung dieses Umladevorganges wird der Schalttransistor T3 wieder geöffnet und die beschriebene Funktion wiederholt sich. Dabei dient als Sollwert für die Deaktivierungszeitpunkte des Schalttransistors T3 der Momentanwert der gleichgerichteten pulsierenden Spannung U+. In der Abfolge dieser Vorgänge, die mit einer gegenüber der Netzfrequenz höheren Folgefrequenz ablaufen, lädt sich der Speicherkondensator C5 auf die geglättete Ausgangsspannung Ua des Schaltnetzteiles auf, deren Pegel über dem Scheitelwert der gleichgerichteten Spannung U+ liegt.

Um die beschriebene Funktion des Schalttransistors T3 zu realisieren, sind ihm entsprechende Steuersignale Ct3 zuzuführen. Wie diese Steuersignale Ct3 erzeugt werden können, ist dem Fachmann durchaus geläufig und hier von untergeordneter Bedeutung. Deshalb ist in Figur 1 lediglich beispielhaft in unterbrochenen Linien und in einem Blockschaltbild schematisch eine solche Möglichkeit angedeutet. Ein Signalgenerator CG detektiert den Momentanwert der gleichgerichteten Spannung U+, ferner über eine Hilfswicklung L11 der Drossel L1 deren Entladevorgänge sowie weiterhin den momentanen Ladungszustand des Speicherkondensators C5 und generiert aus diesen Detektionssignalen die Steuersignale für den Schalttransistor T3.

Aus der vorstehenden Erläuterung des Hochsetzstellers 3, der in Verbindung mit der Gleichrichterbrücke 1 konventionell das Netzteil eines elektronischen Vorschaltgerätes für Leuchtstofflampen bildet, ergibt sich ein relativ hoher Einschaltstrom, wenn der bei Inbetriebnahme zunächst entladene Speicherkondensator C5 aufgeladen wird. Um diese Strombelastung zu kontrollieren, ist nun zwischen der Gleichrichterbrücke 1 und dem Hochsetzsteller 3 der elektronische Schalter 2 angeordnet. Dieser weist ein Transistorschaltglied T1 auf, das insbesondere als N-Kanal-Halbleiterschaltelement ausgebildet ist und mit seiner Schaltstrecke zwischen dem auf hohem Potential liegenden Ausgang RO2 der Gleichrichterbrücke 1 und dem entsprechenden Eingang des Hochsetzstellers 3 angeordnet ist. Dieses Transistorschaltglied kann, je nach Anwendungsfall, als MOSFET, als IGBT (Insulated Gate Bipolar Transistor) oder als sonstiger bipolarer Leistungstransistor ausgebildet sein. Ein weiterer Schalttransistor T2 ist mit seiner Schaltstrecke über einen Vorwiderstand R1, vor dem Transistorschaltglied T1 liegend, zwischen dem auf hohem Potential liegenden Eingang des elektronischen Schalters 2 und Massebezugspotential angeordnet. Der Verbindungspunkt A des Vorwiderstandes R1 mit dem zweiten Schalttransistor T2 ist über einen Eingangswiderstand R2 mit dem Steuereingang des Transistorschaltgliedes T1 verbunden. Außerdem ist dieser Verbindungspunkt A über die Serienschaltung eines weiteren Widerstandes R3 und eine Koppeldiode D6 mit dem auf hohem Potential liegenden Pol des Speicherkondensators C5 verbunden. Ferner ist zwischen dem Emitterausgang des Transistorschaltgliedes T1 und seinem Steuereingang die Parallelschaltung einer Z-Diode D5 sowie eines weiteren Kondensators C3 vorgesehen.

Der elektronische Schalter 2 bleibt deaktiviert und trennt dabei den Ausgang der Gleichrichterbrücke 1 von dem auf hohem Potential liegenden Eingang des Hochsetzstellers 3, sofern der zweite Schalttransistor T2 über ein entsprechendes ihm zugeführtes Steuersignal Ct2 leitend geschaltet ist. Denn dann liegt der Verbindungspunkt A zwischen diesem zweiten Schalttransistor und dem Vorwiderstand R1 auf Massebezugspotential und sperrt das Transistorschaltglied T1.

Um nun den elektronischen Schalter 2 leitend zu schalten, wird der zweite Schalttransistor T2 gesperrt. In diesem Zustand des zweiten Schalttransistors T2 fließt Strom über den Vorwiderstand R1 und den Eingangswiderstand R2, mit dem der an den Steuereingang des Transistorschaltgliedes T1 angekoppelte Kondensator C3 aufgeladen wird. Dabei steigt die Spannung am Steuereingang des Transistorschaltgliedes T1, bedingt durch die Zeitkonstante des RC-Gliedes mit den Widerständen R1, R2 und dem Kondensator C3, langsam an. Infolgedessen wird das Transistorschaltglied T1 auch nicht sofort durchgeschaltet, sondern in einem kontinuierlichen Übergang leitend geschaltet. D. h. es wird der aktive Bereich des Transistorschaltgliedes T1 langsam durchfahren und dabei der Einschaltstrom des angeschlossenen Hochsetzstellers 3 auf einen vorgegebenen Spitzenwert beschränkt.

In dieser Einschaltphase lädt sich der Speicherkondensator C5 des Hochsetzstellers 3 entsprechend langsam auf den Scheitelwert der Netzwechselspannung u∼ auf. Dann wird der Schalttransistor T3 angesteuert. Im stationären Zustand des Hochsetzstellers 3 steht schließlich die hochgesetzte Ausgangsspannung Ua zur Verfügung. Erst dann wird dem Steuereingang des Transistorschaltgliedes T1 eine Hilfsspannung zugeführt, die größer als der Momentanwert der dem elektronischen Schalter 2 zugeführten gleichgerichteten Spannung U+ ist. Diese Hilfsspannung wird der Ausgangsseite des Schaltnetzteiles selbst entnommen und im Beispiel der Schaltungsanordnung von Figur 1 dem Steuereingang des Transistorschaltgliedes T1 über die Koppeldiode D6 und die Widerstände R3, R2 zugeführt. Erst aufgrund dieser Hilfsspannung wird das Transistorschaltglied T1 endgültig in die Sättigung gesteuert, so daß dann seine strombegrenzende Wirkung entfällt.

Die erläuterte Begrenzung des Einschaltstromes des Hochsetzstellers 3 bzw. allgemeiner der an den elektronischen Schalter angeschlossenen Ausgangsstufe des Netzteiles bedeutet nicht nur, daß dessen im betreffenden Strompfad liegende Bauelemente bei Einschaltvorgängen weniger belastet werden, was zu ihrer Verlängerung der Lebensdauer beiträgt und gegebenenfalls auch eine günstigere Dimensionierung ermöglicht. Darüber hinaus wird dadurch, daß das Transistorschaltglied T1 in dem auf hohem Potential liegenden Strompfad angeordnet ist und sich nur auf diesen auswirkt, jeglicher Einfluß auf das Massebezugspotential des Schaltnetzteiles vermieden und damit die eingangs erwähnten, damit verbundenen Nachteile ausgeschlossen. Schließlich wird auf schaltungstechnisch einfache Weise ein Schalter in dem auf hohem Potential liegenden Strompfad realisiert, der mit handelsüblichen N-Kanal-Halbleiterschaltelementen zu implementieren ist. Dies ist vorteilhafter als dafür P-Kanal-Typen mit deren bekannten Nachteilen einsetzen zu müssen.

In Figur 2 ist ein weiteres Ausführungsbeispiel für ein nach dem oben erläuterten Funktionsprinzip arbeitendes Schaltnetzteil dargestellt, dessen Ausgangsstufe in diesem Fall als Sperrwandler 31 ausgebildet ist. Sperrwandler sind als solche hinreichend bekannt, so daß es hier wohl genügt, darauf hinzuweisen, daß in diesem Falle die Drossel L1 des Ausführungsbeispieles von Figur 1 zu einem Transformator TF1 erweitert ist, dessen Primärwicklung - analog dem Ausführungsbeispiel von Figur 1 - über den Schalttransistor T3 an Massebezugspotential gelegt ist. Auch alle übrigen, sonst mit dem in Figur 1 dargestellten Ausführungsbeispiel zumindestens funktional übereinstimmenden Bauelemente der Schaltungsanordnung sind mit übereinstimmenden Bezugszeichen bezeichnet. Insbesondere gilt dies auch für den Speicherkondensator CS, der in diesem Fall der Primärwicklung des Transformators TF1 parallel liegend angeordnet ist.

Zusätzlich ist in diesem Ausführungsbeispiel parallel zu dieser Primärwicklung des Transformators TF1 eine weitere Diode D8 in Serie mit der Parallelschaltung eines weiteren Kondensators C6 und eines weiteren Widerstandes R4 geschaltet. Dieser Parallelzweig zur Primärwicklung des Transformators TF1 bildet ein Spannungsbegrenzungsnetzwerk, dem in diesem Ausführungsbeispiel die Hilfsspannung entnommen wird, um das Transistorschaltglied T1 in die Sättigung zu steuern. Auch hier gilt wie im Ausführungsbeispiel von Figur 1, daß der Speicherkondensator C5 bei einem Einschaltvorgang zunächst auf den Scheitelwert der Netzwechselspannung Ua aufgeladen wird. Sobald dann der Schalttransistor T3 angesteuert wird, stellt sich der stationäre Zustand der geschalteten Leistungseinheit, hier den Sprecherkondensator 5 und den Transformator TF1 umfassend, ein. In dem dessen Primärwicklung parallel liegenden Netzwerk steht dann an der Kathode der Diode D8 eine definierte Spannung an, die die Hilfsspannung für das Durchschalten des Transistorschaltgliedes T1 bildet. Im übrigen sind die Schaltungsteile, die Gleichrichterbrücke 1 und den elektronischen Schalter 2 umfassend, völlig gleichartig wie in dem anhand von Figur 1 beschriebenen ersten Ausführungsbeispiel aufgebaut und bewirken auch die gleichen Schaltungsfunktionen. An dieser Stelle erübrigt es sich daher, Einzelheiten zum Schaltungsaufbau und der Funktion zu wiederholen.

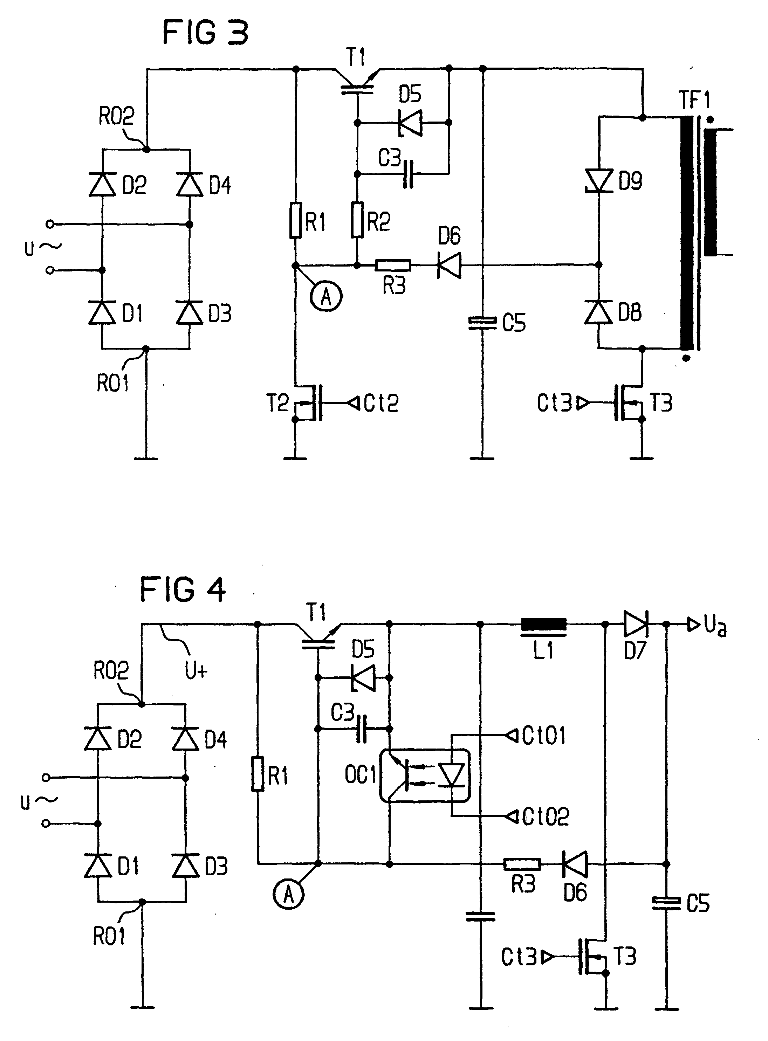

Das in Figur 3 dargestellte Ausführungsbeispiel unterscheidet sich von dem Ausführungsbeispiel nach Figur 2 lediglich in bezug auf das der Primärwicklung des Transformators TF1 parallelgeschaltete Spannungsbegrenzungsnetzwerk. In diesem Falle ist das aus dem Widerstand R4 und dem Kondensator C6 nach Figur 2 gebildete RC-Glied durch eine weitere Z-Diode D9 ersetzt.

In Figur 4 ist in einem weiteren Ausführungsbeispiel eine Alternative für die Ansteuerung des Transistorschaltgliedes T1 dargestellt. Obwohl diese Alternative generell einsetzbar ist, wird sie hier, der Einfachheit halber, in Verbindung mit dem für das erste Ausführungsbeispiel gewählten Hochsetzsteller 3 gezeigt, so daß an dieser Stelle nur noch auf die Schaltungsunterschiede zu Figur 1 hinzuweisen ist.

Im Ausführungsbeispiel von Figur 4 ist die Ansteuerung des Transistorschaltgliedes T1 galvanisch entkoppelt, indem anstelle des zweiten Schalttransistors T2 ein Optokoppler OC1 in dem Netzwerk angeordnet ist, das dem Steuereingang des Transistorschaltgliedes T 1 zugeordnet ist. Schematisch ist angedeutet, daß diesem Optokoppler OC1 an seinen Steuereingängen Ansteuersignale Ct01 bzw. Ct02 zugeführt werden, die den Steuersignalen Ct2 des zweiten Schalttransistors T2 im Ausführungsbeispiel von Figur 1 funktional entsprechen. Die Ausgangsseite des Optokopplers OC1 ist im Ansteuernetzwerk des Transistorschaltgliedes T1 zwischen dem Kondensator C3 und dem Widerstand R3 angeordnet, über den - wie im Ausführungsbeispiel gemäß Figur 1 - dem Transistorschaltglied T1 wiederum die für den Sättigungsbetrieb erforderliche Hilfsspannung zugeführt wird.

Wie im ersten Ausführungsbeispiel gemäß Figur 1 bleibt die Spannung am Steuereingang des Transistorschaltgliedes T1 unterhalb der Schwellenspannung und damit dieses gesperrt, so lange der Ausgangstransistor des Optokopplers OC1 leitet. Wird dagegen der Optokoppler OC1 gesperrt, so wird auch in diesem Fall über den Vorwiderstand R1 der zwischen Emitter und Steuereingang des Transistorschaltgliedes T1 liegende Kondensator C3 aufgeladen und damit die Einschaltfunktion des Transistorschaltgliedes T1 eingeleitet, die bereits im einzelnen anhand des Ausführungsbeispieles von Figur 1 beschrieben wurde und deshalb nicht nochmals erläutert werden muß.

Die beschriebenen Ausführungsbeispiele belegen, daß das erfindungsgemäß ausgebildete elektronische Schaltnetzteil in Verbindung mit einer Vielzahl von jeweils an einen bestimmten Anwendungsfall angepaßten Ausgangsstufen und insbesondere auch dann mit Vorteil einsetzbar ist, wenn das damit versorgte Gerät zu seinem Betrieb eine für Gleichstromversorgungen relativ hohe geglättete Gleichspannung erfordert.

## Patentansprüche

1. Elektronisches Schaltnetzteil mit einer an einer Netzwechselspannung (u∼) liegenden Gleichrichterschaltung (1), die ein Paar von auf hohem Pegel beziehungsweise auf Massebezugspotential liegenden Ausgängen (RO2 bzw. RO1) aufweist und mit einer Ausgangsstufe (3, 31), die eine geglättete Gleichspannung (Ua) liefert und die mit der Gleichrichterschaltung (1) über einen elektronischen Schalter (2) verbunden ist, mit dem die Ausgangsstufe, ausgelöst durch ein dem elektronischen Schalter (2) zugeführtes Schaltsteuersignal (Ct2 bzw. Ct01, Ct02), an die Ausgänge der Gleichrichterschaltung wahlweise anschaltbar ist, wobei der elektronische Schalter (2) ein Transistorschaltglied (T1) und einen Steuertransistor (T2, OC1) umfasst, und wobei das Transistorschaltglied (T1) eine zwischen dem auf hohen Pegel liegenden Ausgang (RO2) der Gleichrichterschaltung (1) und dem entsprechenden Anschluß der Ausgangsstufe (3, 31) angeordnete Schaltstrecke sowie einen Steuereingang aufweist, der über die leitend gehaltene Schaltstrecke des durch das Schaltsteuersignal ansteuerbaren Steuertransistors (T2, OC1) auf Sperrpotential beziehungsweise bei gesperrtem Steuertransistor (T2, OC1) auf Einschaltpotential gehalten wird,
**dadurch gekennzeichnet, dass**
- das Transistorschaltglied (T1) als N-Kanal-Halbleiterelement ausgebildet ist, und
- bei einem durch ein binäres Schaltsteuersignal angesteuerten Steuertransistor (T2 bzw OC1) im Ansteuernetzwerk des Transistorschaltgliedes (T1) ein an die Schaltstrecke des Steuertransistors (T2 bzw. OC1) angekoppeltes Verzögerungsglied (z.B. R1, R2, C3) zum gesteuert verzögerten Einschalten des Transistorschaltgliedes (T1) mit einer vorgegebenen Strombegrenzung vorgesehen ist.

2. Elektronisches Schaltnetzteil nach Anspruch 1, **dadurch gekennzeichnet, dass** die Schaltstrecke des Steuertransistors (T2) einerseits auf Massebezugspotential liegend, andererseits über einen Vorwiderstand (R1) an den auf hohem Potential liegenden Ausgang (RO2) der Gleichrichterschaltung (1) angeschlossen ist und daß ein Verbindungspunkt (A) des Steuertransistors mit dem Vorwiderstand an den Steuereingang des Transistorschaltgliedes angekoppelt ist.

3. Elektronisches Schaltnetzteil nach einem der Ansprüche 1 oder 2, **dadurch gekennzeichnet, dass** das Verzögerungsglied einen Vorwiderstand (R1), der in Serie mit der Schaltstrecke des Steuertransistors (T2) liegend mit dem auf hohem Potential liegenden Ausgang (RO2) der Gleichrichterschaltung (1) verbunden ist sowie eine Reihenschaltung bestehend aus einem weiteren Widerstand (R3) und einem weiteren Kondensator (C3) umfaßt, wobei diese Reihenschaltung an den Verbindungspunkt (A) des Vorwiderstandes (R1) mit dem Steuertransistor (T2) einerseits und den Ausgang des Transistorschaltgliedes (T1) andererseits angeschlossen und ferner ihr Verbindungspunkt des weiteren Widerstandes mit dem weiteren Kondensator an den Steuereingang des Transistorschaltgliedes (T1) angeschlossen ist.

4. Elektronisches Schaltnetzteil nach einem der Ansprüche 1 oder 2, **dadurch gekennzeichnet, dass** der Steuertransistor als Optokoppler (OC1) ausgebildet ist, dessen ausgangsseitige Schaltstrecke dem Kondensator (C3) des Verzögerungsgüedes (R1, R2, C3) parallel geschaltet sind und daß der Steuereingang des Transistorschaltgliedes (T1) ferner über einen Vorwiderstand (R1) an den auf hohem Potential liegenden Ausgang (RO2) der Gleichrichterschaltung (1) angeschlossen ist.

5. Elektronisches Schaltnetzteil nach einem der Ansprüche 1 bis 4, **gekennzeichnet durch** ein zwischen dem Steuereingang des Transistorschaltgliedes (T1) und der Ausgangsstufe (3) angeordnetes Rückopplungsnetzwerk (R3, D6), über das dem Transistorschaltglied (T1) im eingeschwungenen Zustand der Ausgangsstufe (3) eine Hilfsspannung zuführbar ist, mit der das Transistorschaltglied in die Sättigung steuerbar ist.

6. Elektronisches Schaltnetzteil nach einem der Ansprüche 1 bis 5, **dadurch gekennzeichnet, dass** die Ausgangsstufe als ein Hochsetzsteller (3) eines elektronischen Vorschaltgerätes zum Betreiben von Leuchtstofflampen ausgebildet ist, der eine an den Ausgang des Transistorschaltgliedes (T1) angeschlossene Drossel (L1) aufweist, die über eine Koppeldiode (D7) an einen als Elektrolytkondensator ausgebildeten Speicherkondensator (C5) angeschlossen ist, der andererseits auf Massebezugspotential gelegt ist und im eingeschwungenen Zustand die geglättete Gleichspannung (Ua) für die Stromversorgung des elektronischen Vorschaltgerätes liefert.

7. Elektronisches Schaltnetzteil nach Anspruch 6, **dadurch gekennzeichnet, dass** das Rückkopplungsnetzwerk zum Liefern der Hilfsspannung, mit der das Transistorschaltglied (T1) in die Sättigung steuerbar ist, eine Reihenschaltung einer weiteren Diode (D6) und eines weiteren Widerstandes (R3) umfaßt, die zwischen dem Pluspol des Speicherkondensators (C5) und dem Steuereingang des Transistorschaltgliedes angeordnet ist.

## Claims

1. An electronic switched-mode power supply having a rectifier circuit (1) which is connected to an AC supply voltage (u∼) and which has a pair of outputs (RO2 and RO1, respectively) at a high level and at earth reference potential, respectively, and having an output stage (3, 31), which supplies a smoothed DC voltage (Ua) and is connected to the rectifier circuit (1) via an electronic switch (2) with the aid of which the output stage, triggered by a switching control signal (Ct2 or Ct01, Ct02) fed to the electronic switch (2), can be optionally connected to the outputs of the rectifier circuit, the electronic switch (2) comprising a transistor switching element (T1) and a control transistor (T2, OC1), and the transistor switching element (T1) having a switching path, arranged between the high-level output (RO2) of the rectifier circuit (1) and the corresponding terminal of the output stage (3, 31), as well as a control input which is kept at locking potential via the switching path, kept conductive, of the control transistor (T2, OC1), which can be driven by the switching control signal, or is kept at turn-on potential within a blocked control transistor (T2, OC1), **characterized in that**
- the transistor switching element (T1) is designed as an N-channel semiconductor element, and
- given a control transistor (T2 or OC1) driven by a binary switching control signal in the drive network of the transistor switching element (T1), a time-delay element (for example, R1, R2, C3) coupled to the switching path of the control transistor (T2 or OC1) is provided for the purpose of turning on the transistor switching element (T1) with a controlled time delay and with a prescribed current limitation.

2. Electronic switched-mode power supply according to Claim 1, **characterized in that** the switching path of the control transistor (T2) on the one hand is at earth reference potential, and on the other hand is connected via a series resistor (R1) to the high-potential output (RO2) of the rectifier circuit (1), and **in that** the tie point (A) of the control transistor is coupled with the series resistor to the control input of the transistor switching element.

3. Electronic switched-mode power supply according to one of Claims 1 or 2, **characterized in that** the time-delay element comprises a series resistor (R1), which is connected, in series with the switching path of the control transistor (T2), to the high-potential output (RO2) of the rectifier circuit (1), and comprises a series circuit composed of a further resistor (R3) and a further capacitor (C3), this series circuit being connected to the tie point (A) of the series resistor (R1) with the control transistor (T2) on the one hand and to the output of the transistor switching element (T2) on the other hand, and, furthermore, its tie point of the further resistor with the further capacitor being connected to the control input of the transistor switching element (T1).

4. Electronic switched-mode power supply according to one of Claims 1 or 2, **characterized in that** the control transistor is designed as an octocoupler (OC1) whose output-side switching path is connected in parallel with the capacitor (C3) of the time-delay element (R1, R2, C3) and **in that** the control input of the transistor switching element (T1) is further connected via a series resistor (R1) to the high-potential output (RO2) of the rectifier circuit (1).

5. Electronic switched-mode power supply according to one of Claims 1 to 4, **characterized by** a feedback network (R3, D6), arranged between the control input of the transistor switching element (T1) and the output stage (3), via which the transistor switching element (T1) can be fed in the steady-state condition of the output stage (3) an auxiliary voltage with the aid of which the transistor switching element can be driven to saturation.

6. Electronic switched-mode power supply according to one of Claims 1 to 5, **characterized in that** the output stage is designed as a step-up converter (3) of an electronic ballast for operating fluorescent lamps which has an inductor (L1) which is connected to the output of the transistor switching element (T1) and is connected via a coupling diode (D7) to a storage capacitor (C5) which is designed as an electrolytic capacitor and is connected on the other hand to earth reference potential and deploys in the steady-state condition the smoothed DC voltage (Ua) for the power supply of the electronic ballast.

7. Electronic switched-mode power supply according to Claim 6, **characterized in that** the feedback network for supplying the auxiliary voltage with the aid of which the transistor switching element (T1) can be driven to saturation comprises a series circuit, composed of a further diode (D6) and a further resistor (R3), which is arranged between the positive pole of the storage capacitor (C5) and the control input of the transistor switching element.

## Revendications

1. Unité d'alimentation à découpage comportant un circuit redresseur (1), qui se trouve à la tension alternative de réseau (u∼) et qui comporte un couple de sorties (RO2 et RO1) respectivement au niveau haut et au potentiel de référence de masse, et un étage de sortie (3, 31), qui fournit une tension continue lissée (Ua) et qui est relié au circuit redresseur (1) par l'intermédiaire d'un interrupteur électronique (2) avec lequel l'étage de sortie, déclenché par un signal de commande de commutation (Ct2 ou Ct01, Ct02) envoyé à l'interrupteur électronique (2), est raccordable sélectivement aux sorties du circuit redresseur, l'interrupteur électronique (2) comprenant un élément commutateur à transistor (T1) et un transistor de commande (T2, OC1) et l'élément commutateur à transistor (T1) comportant une section de commutation qui est placée entre la sortie au niveau haut (RO2) du circuit redresseur (1) et la borne correspondante de l'étage de sortie (3, 31) ainsi qu'une entrée de commande qui est maintenue respectivement au potentiel de blocage par l'intermédiaire de la section de commutation gardée conductrice du transistor de commande (T2, OC1) commandable par le signal de commande de commutation et au potentiel de branchement lorsque le transistor de commande (T2, OC1) est bloqué,
**caractérisée par le fait que**
- l'élément commutateur à transistor (T1) est conçu comme un élément semi-conducteur à canal N, et
- dans le cas d'un transistor de commande (T2 ou OC1) commandé par un signal de commande de commutation binaire dans le réseau de commande de l'élément commutateur à transistor (T1), il est prévu un élément à retard (par exemple R1, R2, C3) couplé à la section de commutation du transistor de commande (T2 ou OC1) pour le branchement retardé sur commande de l'élément commutateur à transistor (T1) avec une limitation de courant prédéterminée.

2. Unité d'alimentation à découpage selon la revendication 1, **caractérisée par le fait que** la section de commutation du transistor de commande (T2) est raccordée d'une part au potentiel de référence de masse et d'autre part par l'intermédiaire d'une résistance série (R1) à la sortie au potentiel haut (RO2) du circuit redresseur (1) et qu'un point de jonction (A) entre le transistor de commande et la résistance série est couplé à l'entrée de commande de l'élément commutateur à transistor.

3. Unité d'alimentation à découpage selon l'une des revendications 1 ou 2, **caractérisée par le fait que** l'élément à retard comprend une résistance série (R1), qui est reliée en série avec la section de commutation du transistor de commande (T2) à la sortie au potentiel haut (RO2) du circuit redresseur (1), ainsi qu'un circuit série composé d'une autre résistance (R3) et d'un autre condensateur (C3), ce circuit série étant raccordé d'une part au point de jonction (A) entre la résistance série (R1) et le transistor de commande (T2) et d'autre part à la sortie de l'élément commutateur à transistor (T1) et son point de jonction entre l'autre résistance et l'autre condensateur étant raccordé à l'entrée de commande de l'élément commutateur à transistor (T1).

4. Unité d'alimentation à découpage selon l'une des revendications 1 ou 2, **caractérisée par le fait que** le transistor de commande est conçu comme un coupleur optoélectronique (OC1) dont la section de commutation du côté de la sortie est branchée en parallèle avec le condensateur (C3) de l'élément à retard (R1, R2, C3) et que l'entrée de commande de l'élément commutateur à transistor (T1) est raccordée en plus par l'intermédiaire d'une résistance série (R1) à la sortie au potentiel haut (RO2) du circuit redresseur (1).

5. Unité d'alimentation à découpage selon l'une des revendications 1 à 4, **caractérisée par** un réseau de rétroaction (R3, D6) qui est placé entre l'entrée de commande de l'élément commutateur à transistor (T1) et l'étage de sortie (3) et par l'intermédiaire duquel peut être envoyée à l'élément commutateur à transistor (T1), lorsque l'étage de sortie (3) est en régime permanent, une tension auxiliaire avec laquelle l'élément commutateur à transistor est commandable en saturation.

6. Unité d'alimentation à découpage selon l'une des revendications 1 à 5, **caractérisée par le fait que** l'étage de sortie est conçu comme un élévateur de tension (3) qui est destiné à un régulateur électronique de puissance de wattage pour faire fonctionner des lampes fluorescentes et qui comporte une bobine (L1) qui est raccordée à la sortie de l'élément commutateur à transistor (T1) et, par l'intermédiaire d'une diode de couplage (D7) à un condensateur de stockage (C5) qui est conçu comme un condensateur électrochimique, qui est mis d'autre part au potentiel de référence de masse et qui, en régime permanent, fournit la tension continue lissée (Ua) pour l'alimentation en courant du régulateur électronique de puissance de wattage.

7. Unité d'alimentation à découpage selon la revendication 6, **caractérisée par le fait que** le réseau de rétroaction pour fournir la tension auxiliaire avec laquelle l'élément commutateur à transistor (T1) est commandable en saturation comprend un circuit série qui est formé d'une autre diode (D6) et d'une autre résistance (R3) et qui est monté entre le pôle positif du condensateur de stockage (C5) et l'entrée de commande de l'élément commutateur à transistor.
